# EUROPEAN PATENT SPECIFICATION

(11) **EP 1 475 459 B1**
(45) Date of publication and mention of the grant of the patent: **06.05.2009**
(21) Application number: 03703279.4
(22) Date of filing: 10.02.2003
(51) Int. Cl.: C23C 16/00, C08J 7/00

(54) **METHOD FOR MODIFYING SURFACE OF SOLID MATERIAL, SURFACE-MODIFIED SOLID MATERIAL AND DEVICE FOR MODIFYING SURFACE OF SOLID MATERIAL**
VERFAHREN ZUR MODIFIZIERUNG DER OBERFLÄCHE VON FESTEM MATERIAL, OBERFLÄCHENMODIFIZIERTES FESTES MATERIAL UND VORRICHTUNG ZUR MODIFIZIERUNG DER OBERFLÄCHE VON FESTEM MATERIAL
PROCEDE DE MODIFICATION DE LA SURFACE D'UN MATERIAU SOLIDE, MATERIAU SOLIDE A SURFACE MODIFIEE ET DISPOSITIF DE MODIFICATION DE LA SURFACE D'UN MATERIAU SOLIDE

(30) Priority: 13.02.2002 JP 2002035921
(43) Date of publication of application: 10.11.2004
(73) Proprietor: Mori, Yasuhiro, Koto-ku, Tokyo 135-0042 (JP)
(72) Inventor: MORI, Yasuhiro, Koto-ku, Tokyo 135-0042 (JP); DETZNER, Peter, ISIMAT GmbH Siebdruckmachinen, 73479 Ellwangen (DE)
(74) Representative: Hoffmann, Eckart
(86) International application number: PCT/JP2003/001356
(87) International publication number: WO 2003/069017

(56) References cited:
- EP-A1- 0 594 171
- EP-A1- 1 148 036
- WO-A1-98/11154
- DD-A- 256 151
- DE-A1- 10 018 223
- DE-A1- 19 905 697
- FR-A- 2 820 805
- JP-A- 4 059 344
- JP-A- 2000 272 249

## Description

### TECHNICAL FIELD

The present invention relates to a method for modifying a surface of a solid substrate, in particular to a method for modifying the surface of a solid substrate to facilitate adhesion, printing, painting and the like.

### BACKGROUND ART

The surfaces of solid substrates such as silicone rubber, fluorine-contained rubber and polyethylene resin are often hydrophobic and water repellent, making the adhesion of other materials, printing and surface treatment by ultraviolet light painting generally very difficult. Metal surfaces such as stainless steel and magnesium on the other hand show the problem of easy paint film detachment in case of directly applying ultraviolet light curing paint, as the adhesive forces and the surface smoothness of the metals among a variety of kinds of metals are insufficient It has further been tried to add inorganic particles such as titanium oxide particles and zirconium oxide particles into the high polymer as a light catalyst, but the distribution properties are poor and the handling is not easy.

Therefore, as a method of modifying the special surface properties of solid substrates, a primer treatment is applied to the solid substrate surface and/or silane coupling agent and titanium coupling agent solved in a solvent are coated onto the surface.

However, problems with regard to the manufacturing process emerge such as that a relatively large amount of primer and silane coupling agent and that moreover a long treatment time are required in order to achieve a prescribed modification effect.

Therefore, as a method of modifying the special surface properties of solid substrate in place of the primer treatment and the coupling agent treatment, a ultraviolet light irradiation method, a corona discharge treatment, a plasma treatment, an method for adding a surface functional group, a surface light grafting method, a sandblasting treatment, and an acid chromic mixture treatment are exemplified.

For example, Japanese unexamined published patent application No.1993-068934 discloses a method for improving a wettability and an adhesiveness of a painting by irradiating ultraviolet light onto the surface of the hydrophobic plastics using a high pressure mercury lamp with synthetic quartz glass tube. Further, U.S. patent No. 5098618 discloses a method for improving a wettability and an adhesiveness of a painting by selectively irradiating a ultraviolet light having wavelengths of 185 nm and 254 nm onto the surface of the hydrophobic plastics under a mixed gaseous condition. Further, Japanese unexamined published patent application No.1998-067869 discloses a corona treatment method for spraying a gas onto the surface of the plastics having a poor wettability by applying a high voltage pulse. Further, Japanese unexamined published patent application No.1996-109228 discloses a method for graft polymerization of a vinyl monomer on a surface of a polyolefin after an activation treatment, such as an ozone treatment, a plasma treatment, a corona treatment, a high voltage treatment, and an ultraviolet light irradiation method, of the surface of the solid substrate in order to improve a dyestuff-affinity.

However, these methods for modifying the surface of the solid substrate have a variety of problems, such as environmental problems that working environment is contaminated, dangerous, work-related problems that water washing treatment, waste solution treatment are required, economical problems that large scale and expensive facilities are required in addition to a problem that a modification of the surface of the solid substrate is insufficient.

On the other hand, as a simple and cheap method for modifying the surface of the solid substrate, a flame treatment of the surface of the solid substrate may be suggested. However, according to the method, the modification of the surface of the solid substrate, typically wettability and contact angle characteristics, is insufficient and a problem that the modifying effect of the method cannot last for a long-term exists. Further, as Japanese unexamined published patent application No.1997-124810 discloses, in case of applying the flame treatment onto the surface of the solid substrate, a problem that thermal deformation is easily caused exists.

Under the circumstances, as German unexamined published patent application No. DE0010019926A1 discloses, the inventors of the present invention propose a method for modifying a surface of a solid substrate mainly such as a metal substrate or a glass article substrate, comprising the steps of: modification of the surface with at least one oxidizing flame; and modification of the surface with at least one silicatizing flame.

According to the method for modifying the surface of the solid substrate, the surface of the solid substrate may be modified securely and an ink for printing, paint for UV curing and the like may be made to adhere securely.

However, since the disclosed method for modifying a surface of a solid substrate uses, as a silane compound, alkoxysilane having a high boiling temperature such as tetramethoxysilane (boiling temperature: 122 °C) alone, a phenomenon that an imperfect combustion may be seen in case of mixing a large quantity of the alkoxysilane compound with air. Further, since the method separately comprises the oxidizing flame treatment, although a superior modifying effect may be obtained, a problem that a treatment time becomes long exists.

The documents DE 100 18 233A and DE 199 05 697 disclose a process for flame treatment, wherein the flame gas may comprise a modifying agent such as a silane or alkoxysilane.

WO 98/11154 discloses a method according to the pre-characterizing portion of claim 1. More particularly, this document discloses a flame-treating process to modify the surface of a polymeric substrate, e.g., to improve the wetability of the surface. This process disclosed in this document uses for the flame a fuel gas including hexamethyldisiloxane which is known to have a boiling point of 95 to 105°C mixed with an oxidizer.

The inventors of the present invention, as a result of their concentrated efforts, have solved the prior art problems by blow treating the surfaces of the solid substrates and metal substrates with a flame from a fuel gas containing modifying compounds having specific boiling points (silicatizing flame treatment), have found the features of facilitated combustion, even if a relatively large amount of modifying compound containing silicon atoms is used, and of even and sufficient surface modification of the solid substrate, and have completed the present invention.

That is to say, the present invention provides a method for modifying a surface of a solid substrate, a surface modified solid substrate and an apparatus for modifying a surface of a solid substrate respectively, which enable to modify the surface of solid substrates and metal substrates by using the modifying compound burned efficiently and result in a long lasting modification effect

### SUMMARY OF THE INVENTION

According to the present invention, the above-mentioned problems may be solved by providing a method for modifying a surface of a solid substrate wherein the surface of the solid substrate is treated wholly or partly with a flame of a fuel gas which comprises a specific modifying compound which comprises a silicon atom, with the respective boiling point being between 10 and 80° C, the modifying compound being heated, evaporated and then burned.

That is to say, by limiting the modifying compound boiling points to a prescribed range, the modifying compound evaporates moderately and mixes evenly and rapidly with an inflammable gas such as air and a combustion enhancer, and thereby facilitates perfect combustion. As a result, by using such an evenly mixed fuel gas, the surface modification of the solid substrate easily becomes even and the modification effect easily long-lasting.

In case of non-suitable modifying compound boiling points and uneven mixing of modifying compound with inflammable gas, due to accumulation of modifying compound or its cross-links or the like not only in the storage part, but also in the tip part of the burner, a problem such as nozzle clogging arises.

According to the method for modifying a surface of a solid substrate of the present invention, the modifying compound is at least one compound selected from a group consisting of an alkylsilane compound and an alkoxysilane compound.

By using the above compounds for modifying a surface of a solid substrate, ordinary adhesives as a matter of course, but also inks for printing and UV curing type paints may adhere extremely strongly to the surface of a solid substrate such as silicone rubber, and fluorine-contained rubber. Further, by using the above compounds for modifying a surface of a solid substrate, the surface modifying effect may last for a longer term.

According to the method for modifying a surface of a solid substrate of the present invention, at least one compound with a boiling point of 100 °C or above selected from the group consisting of an alkylsilane compound, alkoxysilane compound, alkyltitanium compound, alkoxytitanium compound, alkylaluminum compound and alkoxyaluminum compound is added to the modifying compound in the fuel gas, the added amount preferably having a value in a range from 0.01 to 50 mol% of the total amount of modifying compound.

By adding a compound with a slightly higher boiling point that is extremely well mutually soluble with modifying compound such as an alkyl silane compound, the problems in handling due to the low boiling point of the modifying compound may be improved and the surface modifying effect of the solid substrate may be significantly increased.

According to the method for modifying a surface of a solid substrate of the present invention the amount of the modifying compound in the fuel gas preferably has a value in a range from 1 x 10⁻¹⁰ to 10 mol% of the total amount of fuel gas.

In this way, even if the underground is an electroconductive solid substrate or a colored solid substrate, the surface modifying effect may be achieved in optional places without deterioration of the properties such as electroconductivity and color.

According to the method for modifying a surface of a solid substrate of the present invention, the modifying compound is heated, evaporated and then burned.

In this way, even if modifying compounds such as a silane compound are used in a comparably large amount, by mixing the modifying compound evenly into an inflammable gas, the combustion will be enhanced and the modification of a surface of a solid substrate may be carried out evenly and sufficiently.

According to the method for modifying a surface of a solid substrate of the present invention, fuel gas is preferably obtained by mixing the modifying compound into an air stream.

In this way, even if modifying compounds such as a silane compound are used in a comparably large amount, by mixing the modifying compound evenly into the low-priced air stream, the combustion will be enhanced and the modification of a surface of a solid substrate may be carried out evenly and sufficiently.

According to the method for modifying a surface of a solid substrate of the present invention, the modifying compound is preferably mixed into the air stream by using a carrier gas.

In this way, even if the modifying compound is difficult to transport due to having a comparably large molecular weight and polar groups, by mixing the carrier gas with the modifying compound evenly into the air stream, the combustion will be enhanced and the modification of a surface of a solid substrate may be carried out evenly and sufficiently.

According to the method for modifying a surface of a solid substrate of the present invention, the surface of a solid substrate is preferably treated with the flame while the pressure change of the fuel gas is continuously or intermittently monitored.

In this way, imperfect combustion of the modifying compound may be indirectly prevented and as a result, the modification of a surface of a solid substrate may be carried out evenly and sufficiently.

According to the method for modifying a surface of a solid substrate of the present invention, the wetting index preferably has a value in a range from 40 to 80 mN/m (dyn/cm) (measuring temperature 25 °C).

In this way, ordinary adhesives as a matter of course, but also inks for printing or UV curing type paints can adhere extremely strongly. Further, the surface modifying effect may be kept up for a longer time.

According to the method for modifying a surface of a solid substrate of the present invention, the flame temperature preferably has a value in a range from 500 to 1500 °C.

In this way, imperfect combustion of the modifying compound may be prevented and ordinary adhesives as a matter of course, but also inks for printing or UV curing type paints may adhere extremely strongly to the solid substrate.

Further, with such a flame temperature, while the treatment period is also of some influence, a deformation of the solid substrate may be effectively prevented.

According to the method for modifying a surface of a solid substrate of the present invention, the flame treatment period preferably has a value in a range from 0.1 to 100 seconds.

In this way, imperfect combustion of the modifying compound may be prevented and ordinary adhesives as a matter of course, but also inks for printing or UV curing type paints can adhere extremely rapidly to the solid substrate.

Further, with such a treatment period, while the flame temperature is also of some influence, a deformation of the solid substrate may be effectively prevented.

Another aspect of the present invention is a surface modified solid substrate wherein the surface of the solid substrate is treated wholly or partly with a fuel gas flame so that the wetting index has a value in a range from 40 to 80 mN/m (dyn/cm) (measuring temperature 25° C), the flame from a fuel gas comprising a modifying compound which comprises a silicon atom, a titanium atom or an aluminum atom, with the respective boiling point being between 10 and 80° C.

With this composition, solid substrates or articles obtained thereof may easily be provided wherein ordinary adhesives as a matter of course, but also inks for printing or UV curing (setting) type paints may adhere extremely strongly to the solid substrate. Further, with this composition, the surface modifying effect may be kept up for a longer time.

### BRIEF DESCRIPTION OF THE DRAWINGS

Figure 1 illustrates the structure of a surface modification apparatus.
Figure 2 illustrates the blow treatment process by flame with the surface modification apparatus.
Figure 3 illustrates the structure of a portable surface modification apparatus.
Figures 4 and 5 illustrate the flame blow treatment.

### DESCRIPTION OF THE PREFERRED EMBODIMENTS

Below, with reference to the figures, embodiments regarding the method for modifying a surface of a solid substrate will be explained in detail.

### [First Embodiment]

The first embodiment is a method for modifying a surface of a solid substrate wherein the surface of the solid substrate is blow treated wholly or partly with a flame from a fuel gas, which comprises a modifying compound, with the boiling point being between 10 and 80° C.

### 1. Solid Substrate

According to the first embodiment, the solid substrate used is typically silicone rubber or fluorine-contained rubber or the like. Details will be explained according to the second embodiment.

### 2. Fuel Gas

### (1) Modifying compound

### i) Boiling Point

It is characteristic for the value of the boiling point of the modifying compound under atmospheric pressure to be in a range between 10 and 80° C.

The reason for this is, that if the value of the boiling point of the modifying compound is below 10°C the volatility is extreme and the handling becomes difficult in some cases. On the other hand, if the value of the boiling point of the modifying compound is above 100 °C, the mixing characteristics with inflammable gases and combustion enhancers like air decrease considerably, the modifying compound will tend to imperfect combustion, the surface modification of the solid substrate will be uneven and it will be difficult to keep up the modification effect for a long time.

Therefore, the value of the boiling point of the modifying compound is preferably in a range between 15 and 80 °C, and even more preferably in a range between 20 and 60 °C.

The boiling point of the modifying compound may be adjusted not only by restricting the structure of the modifying compound itself, but also by using an appropriate mixture of compounds with comparatively low boiling points like alkyl silane compounds and compounds with comparatively high boiling points like alkoxysilane compounds.

### ii) Kinds

With respect to the kinds of modifying compounds, without any intention of restriction, compounds such as an alkylsilane compound and an alkoxysilane compound, may be given as an example.

Furthermore, among these compounds, alkylsilane compounds are preferable modifying compounds as they generally have low boiling points for the most part, are easily evaporated by heating and may be mixed evenly with air.

As a preferable example of such an alkylsilane compound tetramethylsilane may be given.

Furthermore, among the above mentioned compounds, alkoxysilane compounds are preferable modifying compounds as long as their boiling point is in a range between 10 and 80° C, for although generally having high boiling points in most part due to their ester structure, they enable an even more excellent surface modifying effect of the solid substrate.

### iii) Average Molecular Weight

It is preferable for the value of the weight mean molecular weight (average molecular weight) of the modifying compound to be within a range of 50 to 1,000 measured by mass spectrum analysis.

The reason for this is, that if the value of the average molecular weight of the modifying compound is below 50 the volatility is high and the handling becomes difficult in some cases. On the other hand, if the value of the average molecular weight of the modifying compound is above 1,000, the evaporation by heating and the easy mixing with air becomes difficult in some cases.

Therefore, it is more preferable for the value of the average molecular weight of the modifying compound to be within a range of 60 to 500, and it is even more preferable for the value of the average molecular weight of the modifying compound to be within a range of 70 to 200, measured by mass spectrum analysis.

### iv) Density

It is preferable for the value of the density of the modifying compound in liquid state to be within a range of 0.3 to 0.9 g/cm³.

The reason for this is, that if the value of the density of the modifying compound in liquid state is below 0.3 g/cm³ the handling becomes difficult and accommodation in aerosol cans becomes a problem in some cases. On the other hand, if the value of the density of the modifying compound in liquid state is above 0.9 g/cm³, the evaporation becomes difficult and in case of accommodation in aerosol cans, a state of complete separation with the air or the like can occur in some cases.

Therefore, it is more preferable for the value of the density of the modifying compound in liquid state to be within a range of 0.4 to 0.8 g/cm³, and it is even more preferable for the value of the density of the modifying compound in liquid state to be within a range of 0.5 to 0.7 g/cm³.

### v) Added Amount

It is preferable for the value of the added amount of the modifying compound to be within a range of 1 x 10⁻¹⁰ to 10 mol% of the total amount of fuel gas.

The reason for this is, that if the value of the density of the modifying compound in liquid state is below 1 x 10⁻¹⁰ mol% the modifying effect of solid substrates does not appear in some cases. On the other hand, if the value of the density of the modifying compound in liquid state is above 10 mol%, the mixing properties of the modifying compound with air decrease leading to imperfect combustion of the modifying compound in some cases.

Therefore, it is more preferable for the value of the density of the modifying compound in liquid state to be within a range of 1 x 10⁻⁹ to 5 mol%, and it is even more preferable for the value of the density of the modifying compound in liquid state to be within a range of 1 x 10⁻⁸ to 1 mol%.

### (2) Inflammable Gas

It is preferable to add an inflammable gas into the fuel gas to allow easy control of the flame temperature. Hydrocarbon gases such as propane gas and natural gas, or inflammable gases such as hydrogen, oxygen, air may be given as such inflammable gases. In case of using inflammable gas accommodated in aerosol cans it is preferable to use propane gas and compressed air.

It is preferable for the value of the contained amount of inflammable gas to be within a range of 80 to 99.9 mol% of the total amount of fuel gas.

The reason for this is, that if the value of the contained amount of inflammable gas is below 80 mol% the mixing properties of the modifying compound and air decrease leading to imperfect combustion of the modifying compound in some cases. On the other hand, if the value of the contained amount of inflammable gas is above 99.9 mol% the modifying effect of solid substrates does not appear in some cases.

Therefore, it is more preferable for the value of the contained amount of inflammable gas to be within a range of 85 to 99 mol%, and it is even more preferable for the value of the contained amount of inflammable gas to be within a range of 90 to 99 mol%.

### (3) Carrier Gas

It is preferable to also add a carrier gas to evenly mix the modifying compound into the fuel gas. That is to say, it is preferable to premix the modifying compound with a carrier gas, and to then mix it into the inflammable gas such as the air stream.

The reason for this is, that by adding a carrier gas, even when using a modifying compound with a relatively high molecular weight that is difficult to transport, it may be evenly mixed into the air stream. That is to say, by adding a carrier gas, the modifying compound becomes easy to burn and the surface modification of the solid substrate may be carried out evenly and sufficiently.

As such a preferable carrier gas it is preferable to use the same type of gas as the inflammable gas, for example, air and oxygen, or hydrocarbon gases such as propane gas and natural gas may be given.

### (4) Additives

### i) Kinds

It is preferable to add at least one compound selected from the group consisting of an alkylsilane compound, alkoxysilane compound, alkyltitanium compound, alkoxytitanium compound, alkylaluminum compound and alkoxyaluminum compound with a boiling point of 100 °C or above into the fuel gas as a modification enhancer.

The reason for this is, that by adding a modification enhancer with excellent mutual solubility to the modifying compound such as alkyl compound, even when using a compound with a relatively high boiling point, due to the boiling point of the modifying compound being low, the fuel gas handling may be improved and as a consequence thereof the surface modification effect of the solid substrate may be further increased.

### ii) Added Amount

It is preferable for the value of the added amount of modification enhancer to be within a range of 0.01 to 50 mol% of the total amount of modifying compound.

The reason for this is, that if the value of the added amount of modification enhancer is below 0.01 mol% the effect of adding modification enhancer will not appear in some cases. On the other hand, if the value of the added amount of modification enhancer is above 50 mol% imperfect combustion of the fuel gas occurs in some cases.

Therefore, it is more preferable for the value of the modification enhancer to be within a range of 0.1 to 30 mol%, and it is even more preferable for the value of the modification enhancer to be within a range of 0.5 to 20 mol%.

### 3. Flame

### (1) Temperature

It is preferable for the value of the flame temperature to be within a range of 500 to 1,500 °C.

The reason for this is, that if the value of the flame temperature is below 500 °C, it becomes difficult to prevent effectively imperfect combustion of the modifying compound in some cases. On the other hand, if the value of the flame temperature is above 1,500 °C, the solid substrate subject to surface modifying will be deformed or damaged in some cases, and the types of solid substrates that may be used will be excessively limited in some cases.

Therefore, it is more preferable for the value of the flame temperature to be within a range of 550 to 1200 °C, and it is even more preferable for the value of the flame temperature to be within a range of 600 to 900 °C.

The flame temperature may be appropriately adjusted according to the type of fuel gas, the fuel gas throughput or the type and amount of modifying compound added to the fuel gas.

### (2) Treatment Period

It is preferable for the value of the flame treatment period (blow period) to be within a range of 0.1 to 100 seconds.

The reason for this is, that if the value of the flame treatment period is below 0.1 seconds, the modifying effect of the modifying compound does not appear evenly in some cases. On the other hand, if the value of the flame treatment period is above 100 seconds, the solid substrate subject to surface modifying will be heat deformed or heat damaged in some cases, and the types of solid substrates that may be used will be excessively limited in some cases.

Therefore, it is more preferable for the value of the flame treatment period to be within a range of 0.3 to 30 seconds, and it is even more preferable for the value of the flame treatment period to be within a range of 0.5 to 20 seconds.

### [Second Embodiment]

The second embodiment is a surface modified solid substrate wherein the surface of the solid substrate is blow treated wholly or partly with a fuel gas flame with the respective boiling point being between 10 and 80° C so that the wetting index has a value in a range from 40 to 80 mN/m (dyn/cm) (measuring temperature 25 °C).

### 1. Solid Substrate

### (1) Rubber

According to the composition of the surface modified solid substrate, for the solid substrate at least one rubber type may be given selected from the group consisting of silicone rubber, fluorine-contained rubber, natural rubber, neoprene rubber, chloroprene rubber, urethane rubber, acryl rubber, olefin rubber, styrene-butadiene rubber, acrylonitrile-butadiene rubber, ethylene-propylene rubber, ethylene-propylenediene rubber, butadiene rubber, butyl rubber, styrene type thermoplastic elastomer and urethane type thermoplastic elastomer.

Among these rubber types an excellent modifying effect may be obtained according to the surface modification of the present invention with large wetting angle of contact, low wetting index silicone rubber, fluorine-contained rubber, olefin rubber, ethylene-propylene rubber. Therefore, it becomes easily to print numbers and letters and the like on the surface of stain-proof rubber and dirt covers such as silicone rubber, and fluorine-contained rubber.

### (2) Resins

According to the composition of the surface modified solid substrate, the solid substrate may be given as at least one resin selected from the group consisting of a polyethylene resin (high density polyethylene, medium density polyethylene, low density polyethylene, high pressure polyethylene, medium pressure polyethylene, low pressure polyethylene, linear low density polyethylene, branch low density polyethylene, high pressure linear low density polyethylene, super molecular weight polyethylene, cross-linked polyethylene), polypropylene resin, denatured polypropylene resin, polymethyl pentene resin, polyester resin, polycarbonate resin, polyether sulfone resin, polyacryl resin, polyether ether ketone resin, polyimide resin, polysulfone resin, polystyrene resin, polyamide resin, and polyphenylen sulfide resin, ethylene-tetrafluoroethylen copolymer, polyvinyl fluoride resin, atetrafluoroethylene-perfluoroether copolymer, tetrafluoroethylene-hexafluoropropylene copolymer, polytetrafluoroethylene resin, polyvinylidene fluoride resin, polytrifluorochloroethylene resin and ethylene-trifluorochloroethylene copolymer.

Among these resin types an excellent modifying effect may be obtained according to the surface modification of the present invention with large wetting angle of contact, a low wetting index polyethylene resin, polypropylene resin, polyester resin, polycarbonate resin, and polytetrafluoroethylene resin.

Therefore, the printing of letters and patterns onto films made of a polyethylene resin or a polypropylene resin, or onto receptacles made of polyester, the firm adhering of aluminum reflecting film to compact disk boards made of a polycarbonate resin and also the printing of numbers and letters and the like onto dirt-repellent material made of a polytetrafluoroethylen resin become possible.

### (3) Thermosetting Resins

According to the composition of the surface modified solid substrate, the solid substrate is at least one thermosetting resin selected from the group comprising of an epoxy resin, phenol resin, cyanate resin, urea resin, and guanamine resin. Among these thermosetting resins, in case of an epoxy resin for example, lasermarking on semiconductor plastic encapsulation resins may be carried out easily according to the surface modification of the present invention.

### (4) Metals

According to the composition of the surface modified solid substrate, one or a combination of two or more from a group comprising aluminum, magnesium, stainless steel, nickel, chromium, tungsten, gold, copper, iron, silver, zinc, tin, and lead are preferable.

For example, aluminum is widely used as a light metal, but shows the problem of an easy surface oxidation layer forming, which leads to easy peeling-off (detachment) of UV curing paint even when applied directly. Now, by carrying out silicatizing flame treatment on the aluminum surface, the peeling-off (detachment) of UV curing paint even when applied directly may be effectively prevented.

Further, magnesium as a recyclable metal is widely used in recent years in personal computer bodies, but shows the problem of easy peeling-off (detachment) of UV curing paint even when applied directly due to poor surface smoothness. Now, by carrying out silicatizing flame treatment on the magnesium surface, the peeling-off (detachment) of UV curing paint even when applied directly may be effectively prevented and colored magnesium sheets may be provided.

Further, currently, when gold bumps or solder bumps of semiconductor elements are electrically connected to film carrier and circuit board in a high temperature and high moisture environment, problems appear with occurring surface detachment Now, by carrying out silicatizing flame treatment on either the gold bumps or solder bumps, or the film carrier or circuit board, the surface detachment may be effectively prevented.

Further, the silicatizing flame treatment is a treatment using a flame which comprises a silicon atom, a titan atom or an aluminum atom, which enables the forming of a silicon oxide layer, titanium oxide layer or an aluminum oxide layer on the whole substrate substance or on part of it by blazing heat decomposition of the substrate substance.

### (5) Inorganic Filler

As a solid substrate composing additive, it is also preferable to add one or a combination of two or more from a group comprising titanium oxide, zirconium oxide, indium oxide, tin oxide, silica, talc, calcium carbonate, lime, zeolite, gold, silver, copper, zinc, nickel, tin, lead, solder, glass, and ceramic.

By adding such an inorganic filler the physical properties such as the mechanical strength, the heat resistance, the electroconductivity or electrical insulation properties may be improved according to the type of inorganic filler. Not only that, by adding an inorganic filler in such a way, the surface of the inorganic filler itself will also be modified taking priority, so that as a result, the surface modifying effect develops even better than in case of a homogeneous solid substrate.

Further, when adding inorganic fillers into the solid substrate, it is preferable for the value of the added amount to be within a range of 0.01 to 80 weight% of the total amount of solid substrate, it is more preferable for the value to be within a range of 0.1 to 50 weight%, and it is even more preferable for the value to be within a range of 1 to 30 weight%.

### (6) Form

The form of the solid substrate undergoing the treatment is not especially restricted, but for example can have a board shape, plate shape, sheet shape, film shape, tape shape, strip shape, panel shape, strap shape plane structure as well as a cylinder shape, column shape, sphere shape, block shape, tube shape, pipe shape, concavo-convex shape, membrane shape, fiber shape, fabrics shape, bundle shape three-dimensional structure.

For example, by carrying out silicatizing flame treatment on fiber glass or carbon fiber, the surface may be modified and activated, and the fibers may be distributed evenly in a matrix resin such as epoxy resin and a polyester resin. Therefore, excellent mechanical strength, heat resistance may be achieved in FRP and CFRP.

Further, as such a form of matter subject to treatment, it is also preferable for it to be of a composite structure such as of a solid substrate combined with a metal part, ceramic part, glass part, paper part, and wooden part.

For example, by carrying out silicatizing flame treatment on the inner side of a metal pipe or a ceramic pipe the surface is modified and activated and a layered pipe with an extremely strong resin liner may be obtained.

Further, by carrying out silicatizing flame treatment wholly or in part of the surface of a board, that is a plastic board or glass board, such as a liquid crystal display device, organic electro luminescence device, plasma display device, or a CRT, an organic film such as a color filter, deflection sheet, light scattering sheet, black matrix sheet, anti-reflection film, anti-static film may be laminated extremely evenly and firmly.

### 2. Fuel Gas

As the same modifying compound and inflammable gas may be used as described in the first embodiment, the description is omitted here.

### 3. Flame

As the same flame temperature and treatment period may be used as described in the first embodiment, the description is omitted here.

### 4. Wetting Index (Surface Energy or Surface Tension)

### (1) After Surface Modification

Further, it is preferable for the value of the wetting index of the surface modified solid substrate to be in a range between 40 and 80 mN/m (dyn/cm) (measuring temperature 25°C).

The reason for this is, that if the value of the wetting index of the solid substrate is below 40 mN/m (dyn/cm), easy adhesion, printing, painting becomes difficult in some cases. On the other hand, if the value of the wetting index of the solid substrate is above 80 mN/m (dyn/cm), the surface treatment is overly carried out and the solid substrate is heat damaged in some cases.

Therefore, it is more preferable for the value of the wetting index of the surface modified solid substrate to be in a range between 45 and 75 mN/m (dyn/cm), and it is even more preferable for the value to be in a range between 50 and 70 mN/m (dyn/cm).

### (2) Before Surface Modification

Further, it is preferable for the value of the wetting index of the solid substrate before surface modification (before surface treatment) to be in a range between 20 and 45 mN/m (dyn/cm) (measuring temperature 25° C).

The reason for this is, that if the value of the wetting index of the solid substrate is below 20 mN/m (dyn/cm), the surface treatment needs to be carried out over a long period, so that the solid substrate is heat damaged in some cases. On the other hand, if the value of the wetting index of the solid substrate is above 45 mN/m (dyn/cm), efficient surface treatment by flame becomes difficult in some cases. For example, the wetting index of polyethylene resin before modification treatment is about 40 mN/m (dyn/cm), and although it also depends on the silicatizing flame treatment temperature, with about 1 second of silicatizing flame treatment the wetting index may be increased to about 60 mN/m (dyn/cm).

Therefore, it is more preferable for the value of the wetting index of the solid substrate before surface modification (before surface treatment) to be in a range between 25 and 38 mN/m (dyn/cm (measuring temperature 25 °C), and it is even more preferable for the value to be in a range between 28 and 36 mN/m (dyn/cm.

### 5. Contact Angle

### (1) After Surface Modification

Further, it is preferable for the value of the contact angle of the surface modified solid substrate, measured using water, to be in a range between 0.1 and 30 degrees (measuring temperature 25 °C).

The reason for this is, that if the value of the contact angle of the solid substrate is below 0.1 degree, the surface treatment is overly carried out, so that the solid substrate is heat damaged in some cases. On the other hand, if the value of the contact angle of the solid substrate is above 30 degrees, easy adhesion, printing, painting and the like becomes difficult in some cases.

Therefore, it is more preferable for the value of the contact angle of the surface modified solid substrate, measured using water, to be in a range between 0.5 and 20 degrees (measuring temperature 25 °C), and it is even more preferable for the value to be in a range between 1 and 10 degrees.

Table 1 shows the wetting index (mN/m (dyn/cm)) of the solid substrate before surface treatment and a measurement example of the wetting index of the solid substrate after surface treatment (for 0.5 seconds) measured using a standard (reference) liquid at 25 °C.

### (2) Before Surface Modification

Further, it is preferable for the value of the contact angle, measured using water, of the solid substrate before surface modification (before surface treatment) to be in a range between 50 and 120 degrees (measuring temperature 25 °C).

The reason for this is, that if the value of the contact angle of the solid substrate is below 50 degrees, efficient surface treatment by flame becomes difficult in some cases. On the other hand, if the value of the contact angle of the solid substrate is above 120 degrees, the surface treatment needs to be carried out over a long period of time, so that the solid substrate is heat damaged in some cases. For example, the contact angle of polytetrafluoroethylene resin before modification treatment is about 108 degrees, and although it also depends on the silicatizing flame treatment temperature, with about 1 second of silicatizing flame treatment the contact angle may be decreased to about below 20 degrees.

Therefore, it is more preferable for the value of the contact angle of the solid substrate before surface modification (before surface treatment), measured using water, to be in a range between 60 and 110 degrees, and it is even more preferable for the value to be in a range between 80 and 100 degrees.

### [Third Embodiment]

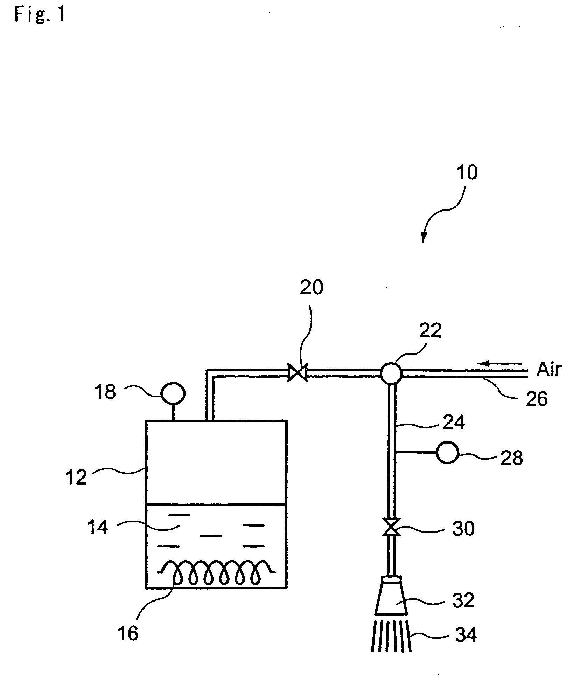

The third embodiment is an apparatus 10 for modifying a surface of a solid substrate, as shown in Figure 1, containing a storage tank 12 for storing a specific modifying compound 14 which comprises a silicon atom, with the respective boiling point being between 10 and 80° C, a transfer part 24 for transferring the fuel gas and an outlet part 32 for letting out the fuel gas flame 34 for blow treatment

### 1. Storage Tank

It is preferable for there to be a first storage tank 12, as shown in Figure 1, for storing the modifying compound 14, having a heating means 16, and a second storage tank (not shown) for storing an inflammable gas such as compressed air. In this example, a heating means 16 is included in the bottom part of the first storage tank 12, the heating means 16 being composed of a heater and heat transfer line, or a heating board or the like that is connected to a heat exchanger, for evaporating the modifying compound 14 being liquid at ambient temperature and atmospheric pressure.

When the solid substrate is surface treated, it is preferable for the modifying compound 14 inside the first storage tank 12 to be heated by the heating means 16 to a predetermined temperature, and in evaporated state to be mixed with the inflammable gas (air etc.) to form the fuel gas.

Furthermore, because the amount of modifying compound included in the fuel gas is of extreme importance, the amount of this modifying compound should also be indirectly controlled. It is therefore preferable to monitor the modifying compound's steam pressure (or the modifying compound amount) by providing a pressure gauge (or a liquid surface level gauge) 18 in the first storage tank 12.

### 2. Transfer Part

The transfer part is usually a pipe structure, and as shown in Figure 1, preferably contains a mixing chamber 22 for forming the fuel gas by evenly mixing the modifying compound 14 transferred from the first storage tank 12 and the inflammable gas (air) transferred from the second storage tank (not shown), as well as a valve and throughput gauge to control the throughput, or a pressure gauge 28 to control the fuel gas pressure.

Further to mixing the modifying compound and inflammable gas evenly, a mixing pump in the mixing chamber 22 in order to strictly control the throughput and an obstruction board or the like to prolong the retention period are preferably included.

### 3. Outlet Part

### (1) Structure

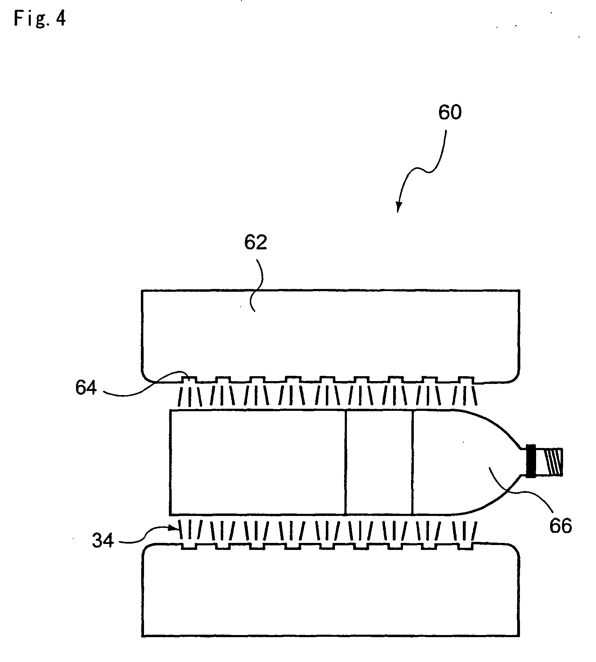

The outlet part, as shown in Figure 1, preferably comprises a burner 32 for blow treatment of the solid substrate subjected to treatment with a flame 34 obtained by burning the fuel gas transferred from the transfer part 24. The type of burner is not particularly restricted, for example, a premixing type burner, a diffusion type burner, a partial-premixing type burner, a spraying burner, an evaporation burner, a pulverized coal burner. Further, the form of burner is not particularly restricted, for example, as shown in Figure 1, the form may be a fan-type as a whole spreading toward the tip portion, or as shown in Figure 4, the form of the burner may be a rectangle with jet nozzles 64 being aligned along the sides.

### (2) Arrangement

It is preferable to determine the arrangement of the outlet part, that is to say, the layout of the burner taking into consideration the ease of surface modification of the solid substrate subject to treatment.

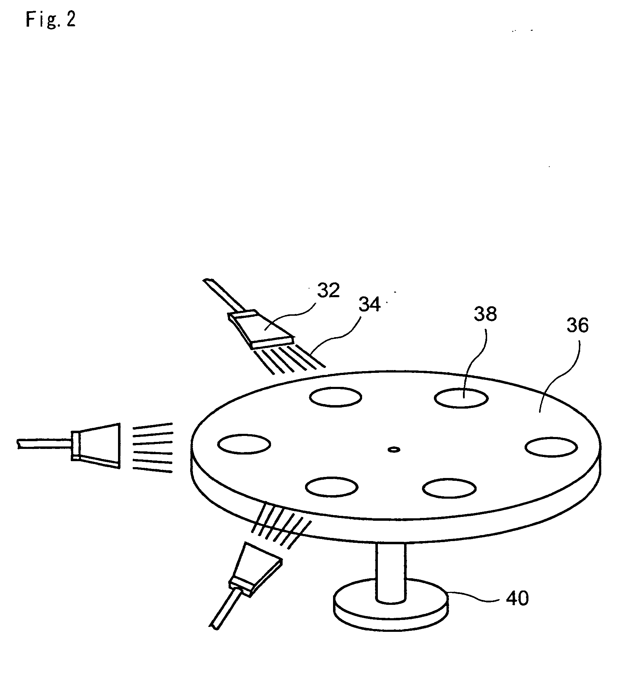

For example, it is preferable to arrange it along a circular or elliptical shape as shown in Figure 2, but it is also preferable to arrange it adjacent to both sides of a solid substrate subject to treatment as shown in Figure 4.

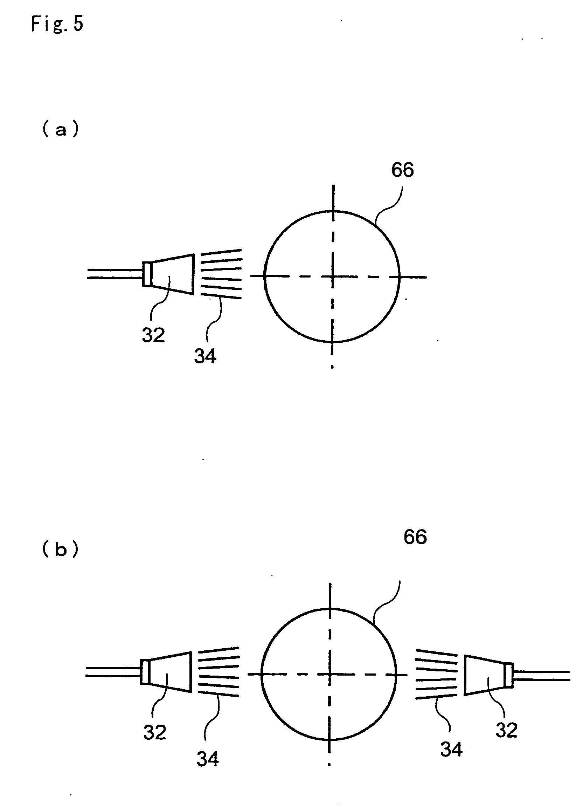

Further, it is also preferable to arrange it at a prescribed distance from one of the sides of a solid substrate subject to treatment as shown in Figure 5 a, but it is also preferable to arrange it at a prescribed distance each from both sides of a solid substrate subject to treatment as shown in Figure 5 b.

### 4. Form

### (1) Stationary Type

The apparatus for modifying a surface of a solid substrate preferably comprises, for example, as shown in Figure 1, a storing tank 12, a transfer part 24 for transferring the fuel gas, and an outlet part 32 for blow treatment with a flame obtained from the fuel gas, and the respective parts are installed. As shown in Figure 2, the solid substrate, mounted on a fixing jig 38 on a rotation table 36, is preferably blow treated with a flame 34 from the outlet part 32 with changing its position of the solid substrate subject to treatment and rotating the solid substrate by the fixing jig 38.

According to the stationary type of apparatus 10 for modifying the surface of the solid substrate, the surface of the solid substrate subject to treatment may be modified in large scale and efficiency.

### (2) Portable Type

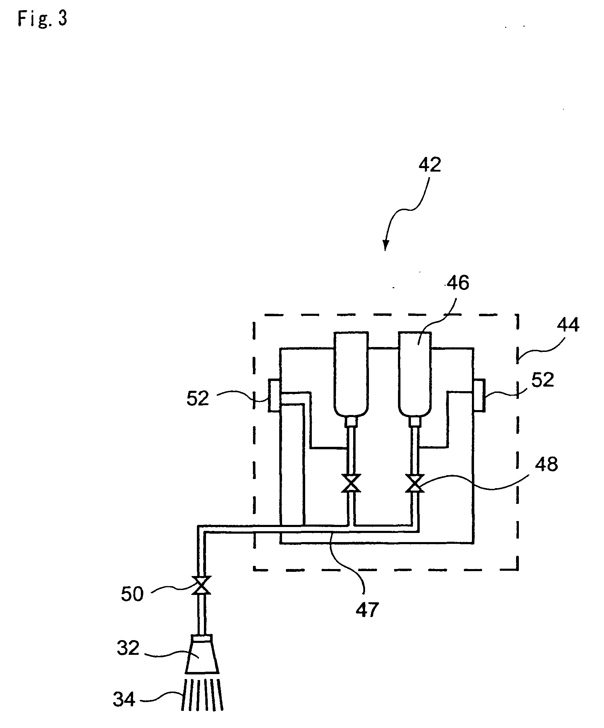

The apparatus for modifying a surface of a solid substrate 42 is preferably a portable type as shown in Figure 3. That is to say, as shown in the region surrounded by the dotted lines, the apparatus comprises a cartridge-type storing tank 46, a laying pipe 47, a box 44 provided with a throughput gauge and a pressure gauge, wherein the laying pipe 47 comprises a burner 32 in its tip portion. According to the above construction, by transferring the box 44 timely, both the solid substance subject to treatment being placed outdoors and the solid substance subject to treatment having a large size and capacity may be surface modified easily.

In order to carry the box easily, the box 44 is preferably provided with a handle or a cord on its upper portion, and the weight of the box 44 is preferably 20 kg or less.

### [Example 1]

### 1. Surface Modification of a Solid Substrate

On a 2mm strong silicone rubber sheet (hardness 80) silicatizing flame treatment was carried out for 0.5 seconds using a portable surface modifying apparatus as shown in Figure 3.

Furthermore, as a fuel gas a mixed gas cartridge was used with 0.0001 mol% of tetramethyl silane having a boiling point at 27 °C, 0.00001 mol% of tetramethoxyl silane having a boiling point at 122 ° C and the remainder being compressed air.

### 2. Evaluation of the Solid Substrate

### (1) Wetting Index (Surface Tension)

The wetting index of a surface modified silicone rubber sheet was measured using a standard liquid. Further, the wetting index of the silicone sheet before surface modification was measured in the same way.

### (2) UV Paint Properties

After screen printing an epoxy-acrylate type UV curing paint onto a surface modified silicone rubber sheet, 300 mJ/cm² of UV rays were irradiated with an UV irradiation apparatus and it was evaluated according to the standard as stated below.

Further, the UV paint properties of the silicone sheet before surface modification were measured in the same way.
very good: According to the cross cut adhesion test of 100 pieces (JIS Standard), no piece was peeled off.
good: According to the cross cut adhesion test of 100 pieces (JIS Standard), 1 or 2 piece(s) was(were) peeled off.
fair: According to the cross cut adhesion test of 100 pieces (JIS Standard), 3 to 10 pieces were peeled off.
bad: According to the cross cut adhesion test of 100 pieces (JIS Standard), more than 11 pieces were peeled off.

### [Examples 2 - 7]

In Examples 2 - 7, as shown in Table 1, the type of solid substrate subject to treatment and the silicatizing flame treatment period were changed, and the surface modified solid substrate was evaluated in the same way as Example 1.

### [Comparison Example 1]

Instead of the mixed gas of compressed air with tetramethylsilane and tetramethoxysilane of Example 1, a mixed gas of compressed air with tetramethoxysilane alone with a boiling point of 122° C was used, but apart from that, the solid substrate was surface modified and evaluated in the same way as in Example 1.

**Table 1**

| | Solid Substrate | Modifying treatment time (sec.) | Wetting index (mN/m (dyn/cm) | | UV Painting | |
|---|---|---|---|---|---|---|
| | | | Before Treatment | After Treatment | Before treatment | After treatment |
| Example 1 | Silicone Rubber | 0.5 | 30 | 60 | bad | very good |
| Example 2 | Silicone Rubber | 0.2 | 30 | 52 | bad | good |
| Example 3 | Polyethylene Board | 1.0 | 32 | 64 | bad | very good |
| Example 4 | Polyethylene Film | 0.2 | 38 | 64 | fair | very good |
| Example 5 | Magnesium Board | 0.5 | 34 | 60 | bad | very good |
| Example 6 | Stainless Steel Board | 0.5 | 34 | 60 | bad | very good |
| Example 7 | Aluminum Board | 0.5 | 32 | 60 | bad | very good |
| Comparison Example 1 | Silicone Rubber | 0.5 | 30 | 48 | bad | fair |

### [Examples 8 - 9 and Comparison Example 2]

In Example 8, after carrying out silicatizing flame treatment in the same way as in Example 1, the shelf period ( rest period ) was changed to 2 weeks and to 4 weeks, and the wetting index and the UV paint properties were each evaluated.

Further, in Example 9, instead of the mixed gas of compressed air with tetramethylsilane and tetramethoxysilane of Example 1, a mixed gas of compressed air with tetramethylsilane was used, and apart from that, after carrying out silicatizing flame treatment in the same way as in Example 1, the rest period was changed to 2 weeks and to 4 weeks, and the wetting index and the UV paint properties were each evaluated.

Further, in Comparison Example 2, instead of silicatizing flame treatment, corona treatment was carried out, and the wetting index and the UV paint properties were each evaluated. Obtained results are shown in Table 2.

**Table 2**

| | Solid Substrate | Modifying Treatment (time) | Wetting Index (mN/m (dyn/cm)) | | UV Painting | |
|---|---|---|---|---|---|---|
| | | | 2weeks | 4weeks | 2weeks | 4weeks |
| Example 8 | Silicone Rubber | silicatizing flame A 0.5 sec. | 60 | 60 | very good | very good |
| Example 9 | Silicone Rubber | silicatizing flame B 0.5 sec. | 60 | 60 | very good | very good |
| Comparison Example 2 | Silicone Rubber | Coronatreatment 10 sec. | 30 | 30 | bad | bad |

| | | | | | | |
|---|---|---|---|---|---|---|
| * silicatizing flame A (tetramethylsilane and tetramethoxysilane) * silicatizing flame B (tetramethylsilane) | | | | | | |

### Industrial applicability

As the above description explains, according to the method for a modifying a surface of a solid substrate in connection with the present invention, by blow treating a solid substrate with a flame of a fuel gas which comprises a modifying compound, with the respective boiling point being between 10 and 80° C, a surface modified solid substrate may be obtained with facilitated adhesion, printing, painting.

Further, even if the surface modified solid substrate is for example a representative of a difficult adhesion material like silicone rubber or fluorine-contained rubber, olefin resin or polyester resin, or a metal such as stainless steel or magnesium, adhesion, printing and painting, that had been impossible up to now, has become easily possible. Consequently, adhesion, printing and painting have easily become possible onto surfaces of a dirt-repellent rubber, a water-repellent rubber, a cushion rubber, a sealing rubber as a matter of course, and also onto products out of these materials with difficult adhesion such as all kinds of switches, covers, levers, vehicle bumpers, electric appliance bodies, electronic part bodies, containers, films, and tapes.

Furthermore, according to the apparatus for modifying a surface of a solid substrate in connection with present invention, by including a storage tank for storing a specific fuel gas, a transfer part for transferring said fuel gas to an outlet part, and an outlet part for blow treating with a fuel gas flame, allows to efficiently obtain a solid substrate facilitating adhesion, printing and painting.

## Claims

1. A method for modifying a surface of a solid substrate, comprising wholly or partly treating the surface of the solid substrate with a flame of a fuel gas which comprises a modifying compound,
wherein the modifying compound is heated and evaporated and, in its evaporated state, the modifying compound is mixed with the fuel gas and is then burned,
**characterized In that** the modifying compound comprises an alkylsilane compound and/or an alkoxysilane compound, with the boiling point of the modifying compound being between 10 and 80° C.

2. The method as recited in claim 1, wherein at least one compound with a boiling point of 100° C or above selected from the group consisting of an alkylsilane compound, alkoxysilane compound, alkyltitanium compound, alkoxytitanium compound, alkylaluminum compound and alkoxyaluminum compound is added to the modifying compound, the added amount having a value in a range from 0.01 to 50 mol% of the total amount of the modifying compound.

3. The method as recited in claim 1 or 2, wherein the amount of the modifying compound in the fuel gas has a value in a range from 1 x 10⁻¹⁰ to 10 mol% of the total amount of fuel gas.

4. The method as recited in any one of claims 1 - 3, wherein the fuel gas is obtained by mixing the modifying compound into an air stream.

5. The method as recited in claim 4, wherein the modifying compound is mixed into the air stream via a carrier gas.

6. The method as recited in any one of claims 1 - 5, wherein the surface of a solid substrate is treated with the flame while the pressure change of the fuel gas is continuously or intermittently monitored.

7. The method as recited in any one of claims 1 - 6, wherein the wetting index after surface modification has a value in a range from 40 to 80 mN/m (dyn/cm) (measuring temperature 25 °C)

8. The method as recited in any one of claims 1 - 7, wherein the flame temperature has a value in a range from 500 to 1500 °C.

9. The method as recited in any one of claims 1 - 8, wherein the flame treatment period has a value in a range from 0.1 to 100 seconds.

10. The method as recited in any one of claims 1 - 9, wherein the solid substrate is at least one inorganic substance selected from the group consisting of aluminum, magnesium, stainless steel, titanium oxide, zinc oxide and zirconium oxide.

11. The method as recited in any one of claims 1 - 9, wherein the solid substrate is at least one rubber selected from the group consisting of silicone rubber, fluorine-contained rubber, natural rubber, neoprene rubber, chloroprene rubber, urethane rubber, acryl rubber, olefin rubber, styrene-butadiene rubber, acrylonitrile-butadiene rubber, ethylene-propylene rubber, ethylene-propylenediene rubber, butadiene rubber, butyl rubber, styrene type thermoplastic elastomer and urethane type thermoplastic elastomer.

12. The method as recited in any one of claims 1 - 9, wherein the solid substrate is at least one resin selected from the group consisting of a polyethylene resin, polypropylene resin, polymethyl pentene resin, polyester resin, polycarbonate resin, polyether sulfone resin, polyacryl resin, polyether ether ketone resin, polyimide resin, polysulfone resin, polystyrene resin, polyamide resin, and polyphenylen sulfide resin, ethylene-tetrafluoroethylen copolymer, polyvinyl fluoride resin, tetrafluoroethylene-perfluoroether copolymer, tetrafluoroethylene-hexafluoropropylene copolymer, polytetrafluoroethylene resin, polyvinylidene fluoride resin, polytrifluorochloroethylene resin and ethylene-trifluorochloroethylene copolymer.

13. The method as recited in any one of claims 1 - 9, wherein the solid substrate is at least one thermosetting resin selected from the group consisting of an epoxy resin, phenol resin, cyanate resin, urea resin, and guanamine resin.

## Patentansprüche

1. Verfahren zum Modifizieren der Oberfläche eines massiven Substrats, das die vollständige oder teilweise Behandlung der Oberfläche des massiven Substrats mit der Flamme eines Brenngases, das eine modifizierende Verbindung umfasst, vorsieht,
wobei die modifizierende Verbindung erwärmt und verdampft wird und im verdampften Zustand mit dem Brenngas gemischt und dann verbrannt wird,
**dadurch gekennzeichnet, dass** die modifizierende Verbindung eine Alkylsilan- und/oder eine Alkoxysilanverbindung umfasst und der Siedepunkt der modifizierenden Verbindung zwischen 10 und 80°C liegt.

2. Verfahren nach Anspruch 1, bei dem mindestens eine Verbindung mit einem Siedepunkt von 100°C oder darüber, ausgewählt aus der Gruppe bestehend aus einer Alkylsilanverbindung, einer Alkoxysilanverbindung, einer Alkyltitanverbindung, einer Alkoxytitanverbindung, einer Alkylaluminiumverbindung und einer Alkoxyaluminiumverbindung, und der modifizierenden Verbindung zugegeben wird, wobei die zugegebene Menge einen Wert im Bereich von 0,01 bis 50 Mol.-% der Gesamtmenge der modifizierenden Verbindung hat.

3. Verfahren nach Anspruch 1 oder 2, bei dem die Menge der modifizierenden Verbindung im Brenngas einen Wert im Bereich von 1x 10⁻¹⁰ bis 10 Mol-% der Gesamtmenge des Brenngases hat.

4. Verfahren nach einem der Ansprüche 1 bis 3, bei dem das Brenngas durch Mischen der modifizierenden Verbindung in einen Luftstrom erhalten wird.

5. Verfahren nach Anspruch 4, bei dem die modifizierende Verbindung über ein Trägergas in den Luftstrom gemischt wird.

6. Verfahren nach einem der Ansprüche 1 bis 5, bei dem die Oberfläche eines massiven Substrats mit der Flamme behandelt wird, während die Druckänderung des Brenngases kontinuierlich oder intermittierend überwacht wird.

7. Verfahren nach einem der Ansprüche 1 bis 6, bei dem der Benetzungsindex nach der Oberflächenmodifizierung einen Wert im Bereich von 40 bis 80 mN/m (dyn/cm) hat (Messtemperatur 25°C).

8. Verfahren nach einem der Ansprüche 1 bis 7, bei dem die Flammentemperatur einen Wert im Bereich von 500 bis 1500°C hat.

9. Verfahren nach einem der Ansprüche 1 bis 8, bei dem die Behandlungsdauer mit der Flamme einen Wert im Bereich von 0,1 bis 100 Sekunden hat.

10. Verfahren nach einem der Ansprüche 1 bis 9, bei dem das massive Substrat mindestens eine anorganische Substanz ist, ausgewählt aus der aus Aluminium, Magnesium, Edelstahl, Titanoxid, Zinkoxid und Zirkoniumoxid bestehenden Gruppe.

11. Verfahren nach einem der Ansprüche 1 bis 9, bei dem das massive Substrat mindestens ein Kautschuk ist, ausgewählt aus der aus Silikonkautschuk, Fluor enthaltenden Kautschuk, Naturkautschuk, Neoprenkautschuk, Chloroprenkautschuk, Urethankautschuk, Acrylkautschuk, Olefinkautschuk, Styrolbutatienkautschuk, Akrylnitrilbutadienkautschuk, Ethylenpropylenkautschuk, Ethylenpropylendienkautschuk, Butadienkautschuk, Butylkautschuk, thermoplastischem Elastomer des Styroltyps und thermoplastischem Elastomer des Urethantyps bestehenden Gruppe.

12. Verfahren nach einem der Ansprüche 1 bis 9, bei dem das massive Substrat mindestens ein Harz ist, ausgewählt aus der aus Polyethylenharz, Polypropylenharz, Polymethylpentenharz, Polyesterharz, Polycarbonatharz, Polyethersulfonharz, Polyacrylharz, Polyetheretherketonharz, Polyimidharz, Polysulfonharz, Polystyrolharz, Polyamidharz und Polyphenylensulfidharz, Ethylentetrafluorethylen-Kopolymer, Polyvinylfluoridharz, Tetrafluorethylenperfluorether-Kopolymer, Tetrafluorethylenhexafluorpropylen-Kopolymer, Polytetrafluorethylenharz, Polyvinylidenfluoridharz, Polytrifluorchlorethylenharz und Ethylentrifluorchlorether bestehenden Gruppe.

13. Verfahren nach einem der Ansprüche 1 bis 9, bei dem das massive Substrat mindestens ein wärmehärtbares Harz ist, ausgewählt aus der aus Epoxyharz, Phenolharz, Cyanatharz, Harnstoffharz und Guaminharz bestehenden Gruppe gewählt wird.

## Revendications

1. Procédé de modification d'une surface d'un substrat solide, dans lequel on traite en tout ou partie la surface du substrat solide par une flamme d'un gaz combustible qui comprend un composé modifiant,
dans lequel on chauffe le composé modifiant et on l'évapore et, en son état évaporé, on le mélange au gaz combustible, puis on le brûle,
**caractérisé en ce que** le composé modifiant comprend un alcoylsilane et/ou un alcoxysilane, le point d'ébullition du composé modifiant étant compris entre 10 et 80°C.

2. Procédé suivant la revendication 1, dans lequel on ajoute au composé modifiant un composé ayant un point d'ébullition supérieur ou égal à 100°C, choisi dans le groupe consistant en un alcoylsilane, un alcoxysilane, un composé alcoyltitanique, un composé alcoxytitanique, un composé alcoylaluminique et un composé alcoxyaluminique, la quantité ajoutée ayant une valeur représentant de 0,01 à 50 % en mole de la quantité totale du composé modifiant.

3. Procédé suivant la revendication 1 ou 2, dans lequel la quantité du composé modifiant dans le gaz combustible a une valeur représentant de 1 X 10⁻¹⁰ à 10 % en mole de la quantité totale du gaz combustible.

4. Procédé suivant l'une quelconque des revendications 1 à 3, dans lequel on obtient le gaz combustible en mélangeant le composé modifiant à un courant d'air.

5. Procédé suivant la revendication 4, dans lequel on mélange le composé modifiant au courant d'air par l'intermédiaire d'un gaz porteur.

6. Procédé suivant l'une quelconque des revendications 1 à 5, dans lequel on traite la surface du substrat solide par la flamme alors que l'on contrôle continuellement ou par intermittence la variation de pression du gaz combustible.

7. Procédé suivant l'une quelconque des revendications 1 à 6, dans lequel l'indice de mouillage après modification de la surface a une valeur comprise entre 40 et 80 mN/m (dyne/cm) (température de mesure 25°C).

8. Procédé suivant l'une quelconque des revendications 1 à 7, dans lequel la température de la flamme a une valeur comprise entre 500 et 1 500°C.

9. Procédé suivant l'une quelconque des revendications 1 à 8, dans lequel la durée de traitement à la flamme a une valeur comprise entre 0,1 et 100 secondes.

10. Procédé suivant l'une quelconque des revendications 1 à 9, dans lequel le substrat solide est au moins une substance minérale choisie dans le groupe consistant en l'aluminium, en le magnésium, en l'acier inoxydable, en l'oxyde de titane, en l'oxyde de zinc et en l'oxyde de zirconium.

11. Procédé suivant l'une quelconque des revendications 1 à 9, dans lequel le substrat solide est au moins un caoutchouc choisi dans le groupe consistant en du caoutchouc de silicone, en du caoutchouc fluoré, en du caoutchouc naturel, en du caoutchouc de néoprène, en du caoutchouc de chloroprène, en du caoutchouc d'uréthane, en du caoutchouc acrylique, en du caoutchouc oléfinique, en du caoutchouc de styrène et de butadiène, en du caoutchouc d'acrylonitrile et de butadiène, en du caoutchouc d'éthylène et de propylène, en du caoutchouc d'éthylène et de propylènediène, en du caoutchouc de butadiène, en du caoutchouc butyl, en un élastomère thermoplastique de type styrénique et en un élastomère thermoplastique de type uréthane.

12. Procédé suivant l'une quelconque des revendications 1 à 9, dans lequel le substrat solide est au moins une résine choisie dans le groupe consistant en une résine de polyéthylène, en une résine de polypropylène, en une résine de polyméthylpentène, en une résine de polyester, en une résine de polycarbonate, en une résine de polyéthersulfone, en une résine polyacrylique, en une résine de polyétheréthercétone, en une résine de polyimide, en une résine de polysulfone, en une résine de polystyrène, en une résine de polyamide et en une résine de poly(sulfure de phénylène), en un copolymère d'éthylène et de tétrafluoroéthylène, en une résine de poly(fluorure de vinyle), en un copolymère de tétrafluoroéthylène et de perfluoroéther, en un copolymère de tétrafluoroéthylène et d'hexafluoropropylène, en une résine de polytétrafluoroéthylène, en une résine de poly(fluorure de vinylidène), en une résine de polytrifluorochloroéthylène et en un copolymère d'éthylène et de trifluorochloroéthylène.

13. Procédé suivant l'une quelconque des revendications 1 à 9, dans lequel le substrat solide est au moins une résine thermodurcissable choisie dans le groupe consistant en une résine époxy, en une résine phénolique, en une résine de cyanate, en une résine d'urée et en une résine de guanamine.
